# EUROPEAN PATENT SPECIFICATION

(11) **EP 1 023 246 B1**
(45) Date of publication and mention of the grant of the patent: **26.11.2003**
(21) Application number: 98944116.7
(22) Date of filing: 25.09.1998
(51) Int. Cl.: C04B 41/50

(54) **DIAMOND CORE WITH A DIAMOND COATING**
DIAMANTPARTIKEL, BESTEHEND AUS EINEM DIAMANTENEM KERN UND EINEM DIAMANTENEM ÜBERZUG
AME DE DIAMANT ET REVETEMENT DE DIAMANT

(30) Priority: 26.09.1997 ZA 9708649
(43) Date of publication of application: 02.08.2000
(73) Proprietor: Element Six (PTY) Ltd, 1559 Springs (ZA)
(72) Inventor: ADIA, Moosa Mahomed, Benoni 1501 (ZA); DAVIES, Geoffrey John, Randburg 2194 (ZA); CHAPMAN, Raymond Albert, Johannesburg 2091 (ZA); HEDGES, Lesley Kay, Brackenhurst 1448 (ZA)
(74) Representative: Carpmaels & Ransford
(86) International application number: GB9802900
(87) International publication number: WO99016729

(56) References cited:
- EP-A- 0 226 898
- EP-A- 0 531 985
- DATABASE WPI Section Ch, Week 9006 Derwent Publications Ltd., London, GB; Class E36, AN 90-040529 XP002088379 & JP 01 317111 A (NORITAKE CO LTD) , 21 December 1989
- DATABASE WPI Section Ch, Week 9622 Derwent Publications Ltd., London, GB; Class L02, AN 96-217096 XP002088380 & JP 08 081271 A (HITACHI TOOL KK) , 26 March 1996

## Description

### BACKGROUND OF THE INVENTION

This invention relates to diamond.

Diamond occurs naturally and is produced synthetically. The outstanding physical properties of diamond make it an ideal material for heat sinks and various abrasive applications such as drilling, grinding, sawing, milling, cutting and the like.

In various applications, particularly grinding, the diamond may be provided with a metal coat to improve its retention in a resin or like matrix.

The synthesis of diamond crystals at high temperature and high pressure is very well established commercially. There are two principal methods employed, both from solution, namely a temperature gradient method and an allotropic change method. In the temperature gradient method, the driving force for crystal growth is the supersaturation due to the difference in solubilities of the source material and the growing crystal as a result of a temperature difference between the two. In the allotropic change method, the driving force for crystal growth is the supersaturation due to the difference in solubilities of the source material and the growing crystal as the result of an allotropic (or polymorphic) difference between the two.

In both cases, the process may be controlled by the use of growth centres. These growth centres may either become incorporated in the grown diamond, or in the case of epitaxial growth, the growth centres are adjuncts to the grown crystal and subsequently detached from the grown crystal deliberately.

When the growth centre is incorporated in the grown crystal, it generally comprises only a small fraction of the volume of the grown diamond, generally less than 1 percent by volume, and does not materially contribute to the physical properties of the grown diamond. Obviously, in the case of the deliberate detachment of external growth centres, there is no growth centre present to contribute to the properties of the grown crystal.

### SUMMARY OF THE INVENTION

According to the present invention, there is provided a diamond product comprising a diamond core and a coating of diamond completely enclosing the diamond core, the diamond core constituting at least 5 percent by volume of the diamond product, the coating diamond being different to that of the core diamond and being predominantly twinned or predominantly single crystal and faceted, or a combination thereof, and both the core diamond and the coating diamond influencing the characteristics of the product.

The diamond coating may be formed from a single layer of diamond which completely encloses the diamond core. Alternatively the diamond coating may be formed from two or more layers of diamond, each layer either partially or completely enclosing the diamond core diamond, provided that the layers as a whole completely enclose the core diamond.

In the diamond product of the invention, the diamond core and the diamond coating both have an influence on, or contribute to, the characteristics of the product. For example, the diamond coating may be such as to increase the impact strength of the diamond core providing the diamond product with an impact strength different to that of the core. Similarly, the diamond core and coating may have differences in thermal stability, oxidation resistance, electrical or other properties. The diamond product may thus have properties which differ from both the core and the coating. The nature of the core diamond and the overgrown layer or coating may be chosen so that the properties in general, or a particular property, of the grown crystal is enhanced. For example, conditions can be chosen such that the overgrown layer or coating is in compression or tension, as desired, or has a higher or lower thermal expansion than the core allowing the mechanical properties of the layered crystal to be modified.

The diamond product of the invention has application, for example, in polishing, lapping, grinding and the manufacture of polycrystalline diamond products.

### DESCRIPTION OF EMBODIMENTS

The core diamond will vary according to the nature of the composite diamond crystal being grown. The core diamond may be natural, synthetic or polycrystalline. The core diamond may be of any desired shape including rounded, acicular, plate, regular or irregular, and may be faceted.

Examples of suitable core diamond include crushed CVD diamond, high temperature-high pressure synthetic diamond made using a known solvent/catalyst, synthetic polycrystalline diamond, such as crushed PCD, and natural single crystal or polycrystalline diamond.

The coating which completely encases the core diamond is of diamond material different to that of the core. Further. the volume of the coating will be such that it allows the coating to influence the characteristics or properties of the product and will generally be at least 5 percent by volume of the diamond product.

In one form of the invention, the core consists of a natural diamond such as diamond of type Ia and a single layer is provided as the coating to enclose the diamond core and this layer or coating is made of synthetic diamond such as diamond of type Ib.

Various other forms of the invention include:
- The core diamond is natural or synthetic diamond and the diamond coating is doped with a dopant such as boron, nitrogen or phosphorus.
- The core diamond is natural or synthetic and the diamond coating has a material such as alumina included therein.
- The core diamond is natural or synthetic and at least two diamond layers, differing in properties, are provided to form the coating. The one diamond layer may be produced synthetically using a catalyst/solvent, e.g. cobalt/iron, and the other produced synthetically using another catalyst/solvent, e.g. nickel/iron.

The diamond product of the invention, and in particular the diamond coating thereof, may be grown or synthesised using high temperature/high pressure conditions. If the known allotropic change method is used, the driving force for crystal growth will be the supersaturation due to the difference in solubilities of the source material, generally graphite, and the growing crystal as the result of an allotropic (polymorphic) difference between the two. If the known temperature gradient method is used, the driving force for crystal growth is the supersaturation due to the difference in solubilities of the source material and the growing crystal as a result of a temperature difference between the two.

The diamond coating may have a predominance of one or other particular form, i.e. it is predominantly twinned, or predominantly single crystal and faceted, or a combination thereof. This may be achieved by growing the crystal under high temperature/high pressure conditions in the presence of a solvent/catalyst, but ensuring that supersaturation, at least in part, is achieved in a particular way.

Thus, the diamond product of the invention may be made by providing a source of diamond crystals, providing a plurality of diamond growth centres, the quantity of source crystals generally being greater than the growth centres, producing a reaction mass by bringing the source crystals and growth centres into contact with a suitable solvent/catalyst, subjecting the reaction mass to conditions of elevated temperature and pressure suitable for crystal growth in the reaction zone of a high temperature/high pressure apparatus for sufficient time to produce the diamond product. and removing the material from the reaction zone. the necessary supersaturation of carbon in the solvent/catalyst being achieved, at least in part. and preferably predominantly, by a selection of particle size difference between the source crystals and the growth centres.

In this form of the invention, the growth centres will constitute the core diamond and the diamond coating grown thereon. The diamond coating produced will be substantially twinned diamond. The twinned diamond coating may include contact twins, macle twins. including multiple and single macle twins, polysynthetic twins and star twins.

The diamond source and the core diamond or growth centre are brought into contact with a suitable solvent/catalyst to create a reaction mass. Generally, the diamond source of carbon and the core diamond will be mixed with the solvent/catalyst in particulate form.

The conditions of diamond synthesis may also be chosen to produce diamond coatings on diamond growth centres which are essentially single crystal and faceted. To produce such diamond products, a source of diamond crystals to be grown is provided, that source being substantially free of macroscopic faceted surfaces. A reaction mass is produced by bringing the source crystals into contact with a suitable solvent/catalyst, subjecting the reaction mass to conditions of elevated temperature and pressure suitable for crystal growth in the reaction zone of a high temperature/high pressure apparatus for sufficient time to produce the diamond product and removing the diamond product from the reaction zone, the conditions of crystal growth being chosen such that the source crystals are converted, and preferably substantially converted, to crystals having developed facets of low Miller index. In this method, a supersaturation driving force depends, at least in part, and preferably predominantly, upon the difference in surface free energy between macroscopic low Miller index surfaces and macroscopic higher Miller index surfaces: higher Miller index surfaces having a higher free energy than lower Miller index surfaces. In the case of diamond, the difference in surface free energy between high Miller index surfaces and low Miller index surfaces is large and can generate a supersaturation which sustains crystallisation. The high Miller index surfaces dissolve and the carbon migrates through the solvent/catalyst and grows or precipitates on the lower Miller index surfaces. The diamond deposited on the lower Miller index surfaces has the characteristics of diamond grown from the solvent/catalyst rather than the characteristics of the core diamond beneath. In this case, the source of carbon is supplied by partial dissolution of the surface of the core diamond itself. An example of a high Miller index surface is a vicinal surface, i.e. a broken stepped surface.

The nature of the solvent/catalyst in the above methods which is used will depend upon the nature of the coating diamond to be grown. Examples of such solvent/catalysts are transition metal elements such as iron, cobalt, nickel, manganese and alloys containing these metals, stainless steels, superalloys e.g. cobalt, nickel and iron-based, bronzes, (including cobalt-containing bronzes) and brazes such as nickel/phosphorus and nickel/chromium/phosphorus and nickel/palladium. Other suitable solvent/catalysts for diamond are elements, compounds and alloys not containing transition metals, e.g. copper, copper/aluminium, copper/niobium and phosphorus, and non-metallic materials or a mixture thereof such as alkaline, alkaline earth or transition metal hydroxides, carbonates, sulphates, chlorates, silicates (such as forsterite and enstatite) and other non-metallic catalysts known in the art.

The conditions of elevated temperature and pressure which are used to produce the diamond product may be those under which diamond is thermodynamically stable. These conditions are well known in the art. However, it is also possible to produce diamond growth under conditions which are outside the region of thermodynamic stability of diamond. Conditions of temperature and pressure outside the region of thermodynamic stability of diamond can be used if the Ostwald rule dominates the growth process rather than the Ostwald-Volmer rule (see S. Bohr, R. Haubner and B. Lux Diamond and Related Materials volume 4, pages 714-719, 1995) - "According to the Ostwald rule, if energy is withdrawn from a system with several energy states, the system will not reach the stable ground state directly, but instead will gradually pass through all intermediate stages. In addition, according to the Ostwald-Volmer rule, the less dense phase is formed (nucleated) first. Where the two rules would appear to contradict each other, the Ostwald-Volmer rule has priority over the Ostwald rule." In the case of diamond crystal growth outside its region of thermodynamic stability, the Ostwald-Volmer rule can be suppressed by, for example, the application of pressure, thus allowing the growth of diamond on pre-existing diamond particles, provided graphite crystals are substantially absent. Although isothermal and isobaric conditions are not essential such conditions are preferred.

The invention will be illustrated by the following examples.

### EXAMPLE 1

A mixture was made of (a) 50g natural irregular diamond particles with a particle size range from 20 to 40 microns, and (b) 285g iron-cobalt powder. The mixture was placed in a reaction capsule which itself was placed in the reaction zone of a conventional high pressure/high temperature apparatus. The contents of the reaction capsule were subjected to a pressure of about 5,5 GPa and a temperature of about 1420°C and these conditions were maintained for a period of 11 hours. The diamond particles at the higher end of the particle size range acted as growth centres, whilst the particles at the lower end of the size range acted as source particles and dissolved preferentially in the solvent/catalyst under the applied conditions. Recovered from the reaction capsule was 41g of diamond particles in the size range 30 to 50 microns. These particles consisted of a core of natural diamond and a coating of synthetic diamond which completely enclosed the core diamond. The synthetic diamond coating was found to have well-defined facets.

### EXAMPLE 2

A mixture was made of (a) 12,6g irregular synthetic diamond particles produced using a cobalt/iron solvent/catalyst and with a particle size in the range 8 to 16 microns and (b) 67,4g of a manganese/nickel (52Mn:48Ni) powder. The mixture was placed in a reaction capsule which itself was placed in the reaction zone of a conventional high pressure/high temperature apparatus. The contents of the reaction capsule were subjected to a pressure of about 5,25GPa and a temperature of about 1360°C, and these conditions were maintained for a period of 40 mins. The irregular diamond particles possessed high Miller index and vicinal surfaces. The high Miller index surfaces dissolved preferentially in the manganese/nickel solvent/catalyst under the applied conditions. The carbon migrated through the solvent/catalyst and deposited on the lower Miller index surfaces. Recovered from the capsule was 10g of diamond particles in the size range 10 to 20 microns. These particles consisted of a core of the synthetic diamond produced using a cobalt/iron solvent/catalyst and a coating of synthetic diamond produced using a manganese/nickel solvent/catalyst which completely enclosed the core diamond. The synthetic diamond coating was found to be predominantly single crystal with octahedral morphology.

### EXAMPLES 3 to 10

The following examples illustrate a range of diamond core sizes and the different solvent/catalysts that have been used to make composite diamond crystals using the method set out in Example 2.

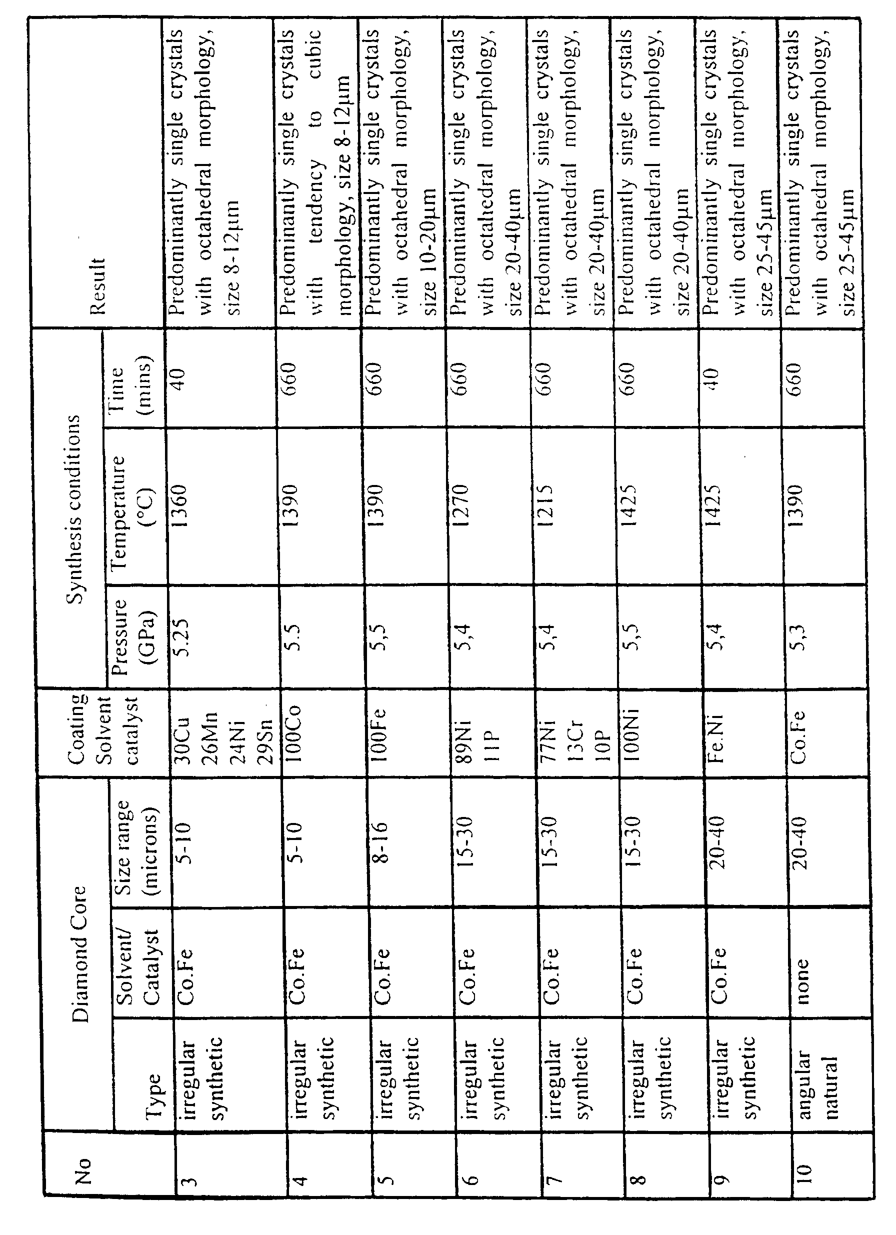

### EXAMPLE 11

A mixture was made (a) 0,5g natural angular diamond particles with a particle size range from about 177 to 250 microns. (b) 24g synthetic diamond particles with a particle size range from 1 to 2 microns and (c) 136g cobalt-iron powder. The mixture was compacted into a cylinder. placed in a reaction capsule, which was then placed in the reaction zone of a conventional high pressure/high temperature apparatus. The contents of the reaction capsule were subjected to a pressure of about 5,3 GPa and a temperature of about 1380°C and these conditions were maintained for a period of 60 minutes. The finer synthetic diamond particles dissolved preferentially in the solvent/catalyst under the applied conditions. The carbon migrated through the solvent/catalyst and deposited on the natural diamond particles. The diamonds were recovered from the capsule by dissolving the solvent/catalyst in a dilute mineral acid mixture. Examination of these diamonds revealed the diamond coatings to comprise almost entirely crystallographically twinned crystals. The composite crystals were in the size range 200 to 350 microns.

### EXAMPLES 12 to 25

The following examples illustrate a range of diamond core sizes and types, source carbon sizes and the different solvent/catalysts that have been used to make composite diamond crystals using the method set out in Example 11.

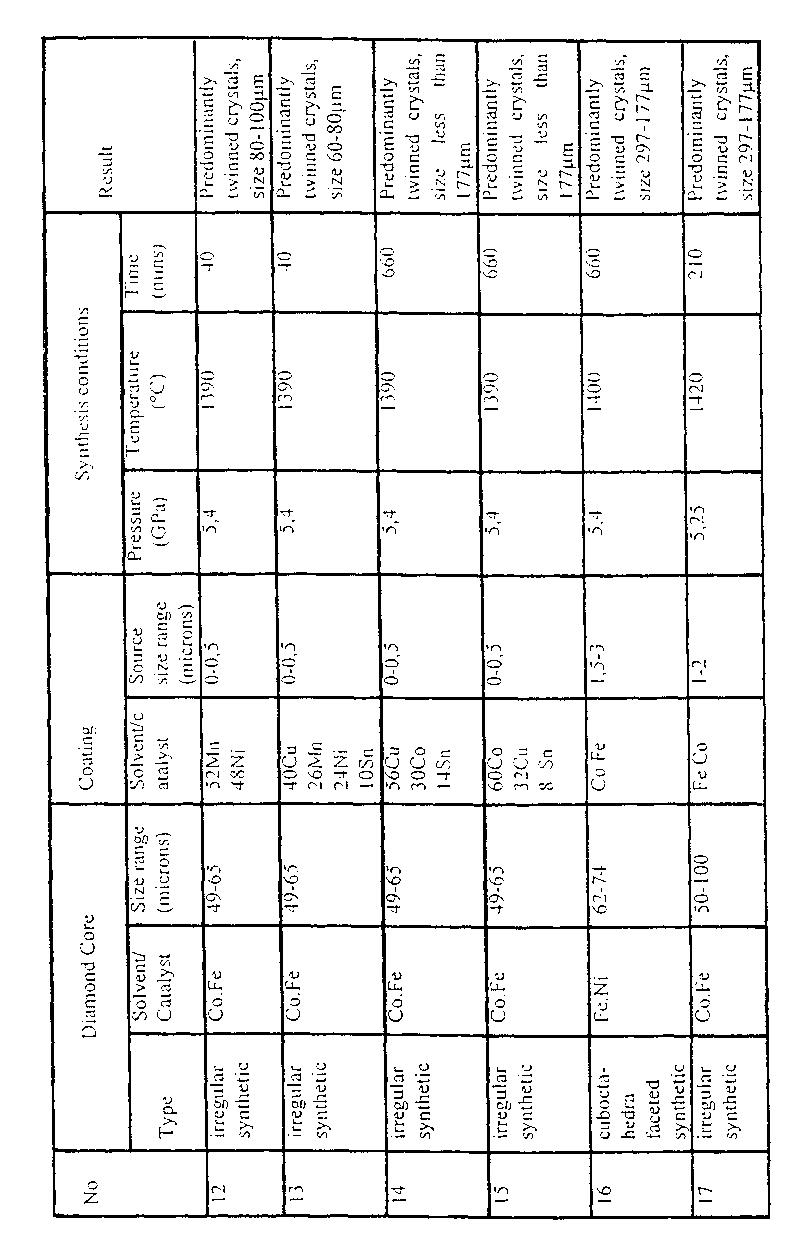

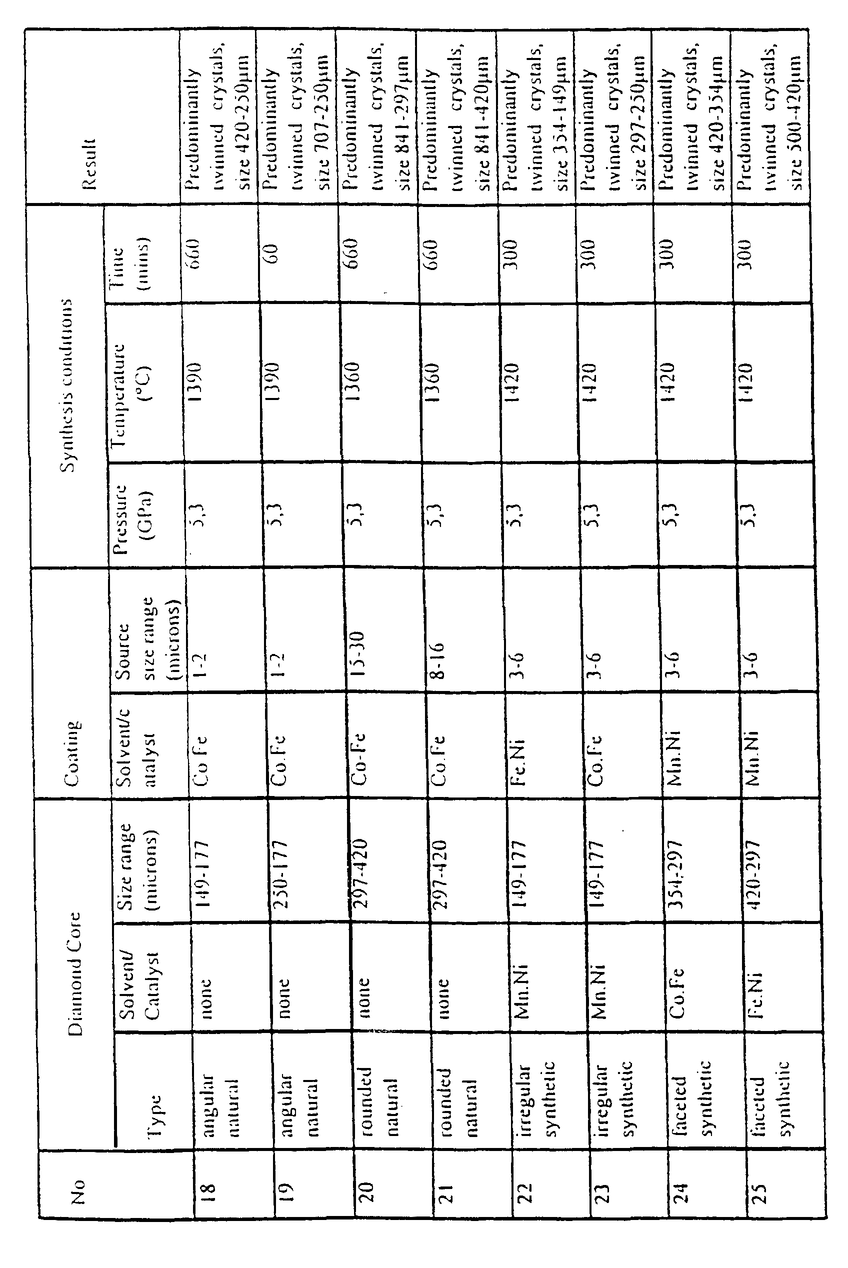

### EXAMPLE 26

A further mixture was made by mixing (a) 36g natural graphite powder as a source of carbon, (b) 0,72g natural diamond particles with a particle size range from 250-177 microns as diamond cores and (c) 204g cobalt-iron powder as solvent/catalyst. The mixture was compacted into a cylinder, placed in a reaction capsule, which was then placed in the reaction zone of a conventional high pressure/high temperature apparatus. The contents of the reaction capsule were subjected to a pressure of about 5,2 GPa and a temperature of about 1360°C and these conditions were maintained for a period of 540 minutes. The graphite powder particles dissolved preferentially in the solvent/catalyst under the applied conditions. The carbon migrated through the solvent/catalyst and deposited on the natural diamond particles. The diamonds were recovered from the capsule by dissolving the solvent/catalyst in a dilute mineral acid mixture. Examination of these diamonds revealed the mass to comprise predominantly crystallographically twinned crystals. These crystals were in the size range 200 to 350 microns.

### EXAMPLE 27

A mixture was made comprising (a) 59,1 g mixed iron and nickel powders, as the solvent/catalyst, (b) 10,9g synthetic diamond powder with a size range from 3 to 6 microns. and (c) 0,167g composite diamond particles recovered from Example 21, screened to be 420-297 microns. The mixture was compacted into a cylinder, placed in a reaction capsule, which was then placed in the reaction zone of a conventional high pressure/high temperature apparatus. The contents of the reaction capsule were subjected to a pressure of about 5,3 GPa and a temperature of about 1410°C and these conditions were maintained for a period of 300 minutes. The diamonds were recovered by dissolving the solvent/catalyst in a mixture of dilute mineral acids. Optical examination of the crystals showed them to be predominantly twinned with a size range of 841-500 microns. These composite diamonds comprised an inner core of natural diamond enclosed in a coating of diamond synthesised in a cobalt-iron solvent/catalyst, which itself was enclosed in a coating of diamond synthesised using an iron-nickel solvent catalyst.

### EXAMPLE 28

A mixture was made comprising (a) 59,1g mixed iron and nickel powders, as the solvent/catalyst, (b) 10,9g synthetic diamond powder with a size range from 3 to 6 microns, and (c) 0,105g blue boron-doped diamond crystals with a size 250-177 microns. The mixture was compacted into a cylinder, placed in a reaction capsule, which was then placed in the reaction zone of a conventional high pressure/high temperature apparatus. The contents of the reaction capsule were subjected to a pressure of about 5,3 GPa and a temperature of about 1410°C and these conditions were maintained for a period of 300 minutes. The diamonds were recovered by dissolving the solvent/catalyst in a mixture of dilute mineral acids. Optical examination of the crystals in transmitted light showed clearly the blue diamond core contrasted against the near colourless diamond coating. The composite diamond crystals ranged in size from 707-500 microns approximately.

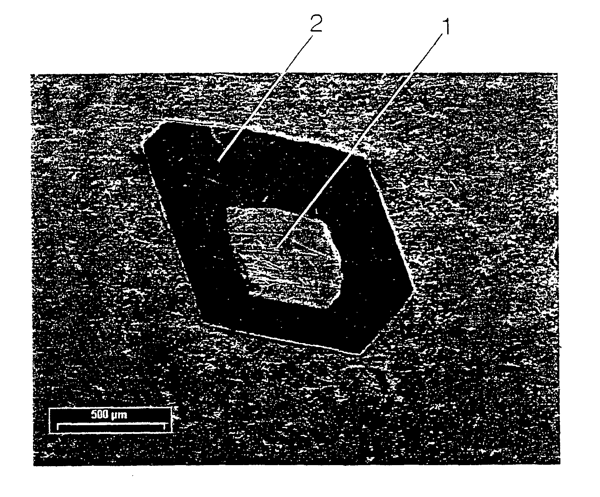

The attached Figure shows an electronmicrograph of a section through a composite diamond crystal or diamond product of the invention at a magnification of 50 times. The electronmicrograph image shows a natural diamond core 1 at the centre of the crystal (light grey area) surrounded by a layer 2 of synthetic diamond (darker grey area) grown in a cobalt-iron solvent/catalyst using synthetic diamond as the carbon source. The diamond core is about 440 microns across and the size of the composite crystal is about 970 microns. The core represents about 9 percent by volume of the composite crystal.

## Claims

1. A diamond product comprising a diamond core and a coating of diamond completely enclosing the diamond core, the diamond core constituting at least 5 percent by volume of the diamond product, the coating diamond being different to that of the core diamond and being predominantly twinned or predominantly single crystal and faceted, or a combination thereof, and both the core diamond and the coating diamond influencing the characteristics of the product.

2. A diamond product according to claim 1 wherein the diamond coating constitutes at least 5 percent by volume of the diamond product.

3. A diamond product according to claim 1 or claim 2 wherein the diamond coating is formed from a single layer of diamond which completely encloses the diamond core.

4. A diamond product according to claim 1 or claim 2 wherein the diamond coating is formed from two or more layers of diamond, each layer either partially or completely enclosing the diamond core, provided that the layers as a whole completely enclose the diamond core.

5. A diamond product according to any one of the preceding claims wherein the core is natural diamond and the coating is synthetic diamond.

6. A diamond product according to any one of claims 1 to 4 wherein both the core and the coating are synthetic diamond.

7. A diamond product according to claim 6 wherein the core diamond is produced synthetically using a solvent-catalyst and the coating diamond is produced synthetically using another solvent/catalyst.

8. A diamond product according to any one of the preceding claims wherein the diamond coating is predominantly twinned diamond.

9. A diamond product according to any one of the preceding claims wherein the diamond coating is predominantly single crystal and faceted.

## Patentansprüche

1. Diamantprodukt, das einen Diamantkern und eine Beschichtung aus Diamant, die den Diamantkern vollständig einschließt, umfasst, wobei der Diamantkern wenigstens 5 Volumenprozent des Diamantprodukts ausmacht, wobei der Beschichtungsdiamant von dem Kerndiamant verschieden ist und vorwiegend verzwillingt oder vorwiegend einkristallin und facettiert oder eine Kombination davon ist und sowohl der Kerndiamant als auch der Beschichtungsdiamant die Eigenschaften des Produkts beeinflussen.

2. Diamantprodukt gemäß Anspruch 1, wobei die Diamantbeschichtung wenigstens 5 Volumenprozent des Diamantprodukts ausmacht.

3. Diamantprodukt gemäß Anspruch 1 oder 2, wobei die Diamantbeschichtung aus einer einzigen Diamantschicht gebildet ist, die den Diamantkern vollständig einschließt.

4. Diamantprodukt gemäß Anspruch 1 oder 2, wobei die Diamantbeschichtung aus zwei oder mehr Diamantschichten gebildet ist, wobei jede Schicht den Diamantkern entweder teilweise oder vollständig einschließt, vorausgesetzt, dass die Schichten als Ganzes den Diamantkern vollständig einschließen.

5. Diamantprodukt gemäß einem der vorstehenden Ansprüche, wobei der Kern aus natürlichem Diamant besteht und die Beschichtung aus synthetischem Diamant besteht.

6. Diamantprodukt gemäß einem der Ansprüche 1 bis 4, wobei sowohl der Kern als auch die Beschichtung aus synthetischem Diamant bestehen.

7. Diamantprodukt gemäß Anspruch 6, wobei der Kemdiamant unter Verwendung eines Lösungsmittels-Katatysators synthetisch hergestellt wird und der Beschichtungsdiamant unter Verwendung eines anderen Lösungsmittels-Katalysators synthetisch hergestellt wird.

8. Diamantprodukt gemäß einem der vorstehenden Ansprüche, wobei die Diamantbeschichtung vorwiegend aus verzwillingtem Diamant besteht.

9. Diamantprodukt gemäß einem der vorstehenden Ansprüche, wobei die Diamantbeschichtung vorwiegend einkristallin und facettiert ist.

## Revendications

1. Produit à base de diamant comprenant un noyau de diamant et un revêtement de diamant entourant complètement le noyau de diamant, le noyau de diamant constituant au moins 5 pour cent en volume du produit à base de diamant, le diamant de revêtement étant différent de celui du diamant noyau et étant essentiellement jumelé ou essentiellement un cristal simple et facetté ou une combinaison de ceux-ci et à la fois le diamant noyau et le diamant de revêtement influençant les caractéristiques du produit.

2. Produit à base de diamant selon la revendication 1 dans lequel le revêtement de diamant constitue au moins 5 pour cent en volume du produit à base de diamant.

3. Produit à base de diamant selon la revendication 1 ou la revendication 2 dans lequel le revêtement de diamant est formé d'une couche simple de diamant qui entoure complètement le noyau de diamant.

4. Produit à base de diamant selon la revendication 1 ou la revendication 2 dans lequel le revêtement de diamant est formé de deux couches ou plus de diamant, l'une ou l'autre des couches entourant partiellement ou complètement le noyau de diamant, à condition que les couches prises dans leur ensemble entourent complètement le noyau de diamant.

5. Produit à base de diamant selon l'une quelconque des revendications précédentes dans lequel le noyau est du diamant naturel et le revêtement est du diamant synthétique.

6. Produit à base de diamant selon l'une quelconque des revendications 1 à 4 dans lequel à la fois le noyau et le revêtement sont du diamant synthétique.

7. Produit à base de diamant selon la revendication 6 dans lequel le diamant noyau est fabriqué synthétiquement à l'aide d'un solvant-catalyseur et le diamant de revêtement est produit synthétiquement en employant un autre solvant-catalyseur.

8. Produit à base de diamant selon l'une quelconque des revendications précédentes dans lequel le revêtement de diamant est essentiellement du diamant jumelé.

9. Produit à base de diamant selon l'une quelconque des revendications précédentes dans lequel le revêtement de diamant est essentiellement du cristal simple et facetté.
